# FASCICULE DE BREVET EUROPEEN

(11) **EP 1 084 597 B1**
(45) Date de publication et mention de la délivrance du brevet: **27.03.2002**
(21) Numéro de dépôt: 99923670.6
(22) Date de dépôt: 04.06.1999
(51) Int. Cl.: H05K 7/14

(54) **DISPOSITIF D'INSERTION, D'EXTRACTION ET DE VERROUILLAGE D'UN MODULE DANS UNE BAIE**
EIN- UND AUSZIEHVORRICHTUNG ZUM VERRIEGELN EINES MODULS IN EINEM BAUGRUPPENTRÄGER
DEVICE FOR INSERTING, EXTRACTING AND LOCKING A MODULE IN A RACK

(30) Priorité: 12.06.1998 FR 9807445
(43) Date de publication de la demande: 21.03.2001
(73) Titulaire: THALES AVIONICS S.A., 78141 Vélizy Villacoublay Cédex (FR)
(72) Inventeur: SARNO, Claude, 94117 Arcueil Cedex (FR); BOUTEILLE, Henri, 94117 Arcueil Cedex (FR)
(74) Mandataire: Guérin, Michel
(86) Numéro de dépôt international: FR9901322
(87) Numéro de publication internationale: WO9966772

(56) Documents cités:
- EP-A- 0 699 019
- FR-A- 2 588 440
- US-A- 4 506 439
- PATENT ABSTRACTS OF JAPAN vol. 018, no. 593 (E-1629), 11 novembre 1994 (1994-11-11) & JP 06 224574 A (HITACHI LTD;OTHERS: 01), 12 août 1994 (1994-08-12)

## Description

La présente invention se rapporte à un dispositif d'insertion, d'extraction et de verrouillage d'un module dans une baie, ce module devant être connecté à un ou plusieurs éléments de connexion lorsqu'il est inséré dans la baie. La connexion peut être notamment de type électrique, on peut envisager que la connexion soit d'un ou plusieurs autres types, par exemple optique, mécanique, pneumatique, thermique...

La description qui va être faite s'appliquera à une connexion électrique mais elle pourrait tout aussi bien concerner une connexion d'autre type.

Un module portant une ou plusieurs cartes de circuits imprimés est destiné à s'engager à la façon d'un tiroir dans une baie. Le module possède des éléments de connexion qui viennent s'enficher sur d'autres éléments de connexion solidaires de la baie.

Lors d'une insertion, le dispositif d'insertion, d'extraction et de verrouillage doit vaincre des forces dues aux éléments de connexion. Il doit également permettre le respect d'une sequence d'étapes précédant la connexion proprement dite, telles qu'un préguidage du module dans la baie, un décodage du module permettant d'être sûr que le module engagé est le bon et que son orientation est correcte.

Lorsque le module est totalement engagé dans la baie, ses cartes de circuit imprimé sont connectées à une installation électrique via les éléments de connexion et le dispositif d'insertion, d'extraction et de verrouillage, dans sa position verrouillée, doit empêcher une déconnexion accidentelle et assurer une bonne liaison même dans des conditions sévères d'utilisation, par exemple lors de vibrations importantes, de chocs, d'accélérations brutales, en atmosphère humide et/ou saline.

Lors de l'extraction, le dispositif d'insertion, d'extraction et de verrouillage doit permettre de vaincre les efforts de désenfichage des éléments de connexion.

Les installations concernées peuvent être, mais non exclusivement, situées à bord d'aérodynes. Dans cette application notamment, la sécurité des connexions est primordiale, des microcoupures dans les liaisons électriques ou autres peuvent être particulièrement gênantes et dangereuses en cas de travail en temps réel, en procédure d'acquisition de données ou de commande d'organes de l'aérodyne....

On cherche, notamment dans les systèmes d'avionique modulaire intégrée que la maintenance de tels modules soit simple et performante. Les modules doivent pouvoir être installés rapidement et leur connexion présenter une grande sécurité.

Une déconnexion et une libération rapide des modules doit aussi être possible pour une réparation ou un échange.

Un dispositif d'insertion, d'extraction et de verrouillage est connu, par exemple, par la demande de brevet FR 2 742 588. Il comporte un levier mobile en rotation, solidaire du module, avec à l'une de ses extrémités un crochet destiné à s'accrocher sur un axe d'ancrage relié à la baie, généralement à sa base, et solidaire d'un ressort. Le ressort en étant fixé d'un côté sur la baie et de l'autre sur l'axe d'ancrage exerce une force de rappel dirigée vers l'intérieur de la baie lorsque le crochet est accroché sur l'axe d'ancrage. L'autre extrémité du levier comporte des moyens d'accrochage du levier sur le module. En position verrouillée, grâce au ressort un effort rémanent s'exerce sur les connexions.

Un tel dispositif n'apporte pas toute satisfaction. En effet, dans des conditions d'environnement à fortes vibrations, des déconnexions accidentelles peuvent intervenir.

Le dispositif d'insertion, d'extraction et de verrouillage ne réalise une solidarisation du module dans la baie qu'au niveau du crochet à la base de la baie.

En cas de vibrations, le module peut osciller dans la baie. Généralement la baie comporte deux glissières en vis-à-vis, l'une en haut, l'autre à sa base et le module est glissé dans ces glissières. Mais un certain jeu est prévu entre le module et les glissières pour tenir compte des tolérances du module et de celles de la baie. Les connexions situées en fond de baie, en diagonale par rapport au point d'ancrage peuvent alors être perturbées si le module vibre et prend du ballant.

Un autre inconvénient de ce dispositif d'insertion, d'extraction et de verrouillage est lié à l'encombrement des pièces du dispositif portées par la base de la baie. La baie porte le ressort et l'axe d'ancrage du crochet. Il faut aménager un espace pour loger ces pièces et cet espace empiète sur le volume de rangement des modules. Les cartes de circuit imprimé logées dans les modules ont une superficie plus réduite que celle de cartes placées dans des modules associés à des dispositifs d'insertion et, d'extraction en forme de simples leviers mais ne remplissant pas la fonction de maintien permanent de l'effort.

Il s'est aussi avéré que ce dispositif d'insertion, d'extraction et de verrouillage ne peut garantir une connexion correcte et complète du module à chaque insertion. En cas de résistance anormale ou excessive des blocs de connexion ou lors de l'apparition d'un obstacle quelconque pendant l'insertion, le ressort de rappel peut se comprimer complètement et le levier peut être verrouillé sans que le module soit complètement et sûrement engagé dans la baie. Les éléments de connexion risquent d'être faussés ou détériorés sans que l'opérateur qui vient d'effectuer cette fausse manoeuvre ne s'en aperçoive.

La présente invention a pour but d'offrir un dispositif d'insertion, d'extraction et de verrouillage particulièrement fiable, garantissant une connexion non perturbée lors d'un fonctionnement dans un environnement sévère.

Un autre but de la présente invention est d'offrir un dispositif d'insertion, d'extraction et de verrouillage qui empêche toute connexion incorrecte ou incomplète du module.

C'est également un but de la présente invention d'offrir un dispositif d'insertion, d'extraction et de verrouillage compatible avec les modules standards et les baies existantes.

Pour y parvenir la présente invention est un dispositif d'insertion, d'extraction et de verrouillage d'un module dans une baie, comportant :
deux bras pivotants par rapport au module articulés l'un à l'autre par une articulation commune, chacun d'entre eux comportant d'une part, à une extrémité, des moyens d'ancrage dans la baie et d'autre part une articulation propre avec le module,
des moyens susceptibles d'immobiliser l'un des bras par rapport à l'autre lorsque les deux bras sont ancrés dans la baie et,
associé à au moins un des bras, des moyens élastiques travaillant en compression entre le module et ledit bras lorsque son extrémité est ancrée dans la baie.

Les moyens élastiques peuvent comporter un ou plusieurs éléments tels que des ressorts ou des rondelles Belleville.

Lorsqu'on utilise des rondelles Belleville, elles peuvent former un ou plusieurs paquets comprenant chacun une ou plusieurs premières rondelles Belleville montées dans un premier sens et une ou plusieurs secondes rondelles Belleville montées dans un second sens, le premier sens étant opposé au second sens, de manière à obtenir une raideur tout à fait adaptée au module et aux efforts qu'il subit.

Selon une première configuration du dispositif d'insertion, d'extraction et de verrouillage, l'articulation propre à un bras peut comporter une chape solidaire du module, cette chape possédant deux branches qui soutiennent un axe de pivotement passant au travers d'une lumière du bras.

Selon une autre configuration, l'articulation propre à un bras peut comporter un axe qui se projette depuis le module à travers une lumière portée par ledit bras, le bras étant maintenu sur l'axe par une goupille blocable en translation.

Un certain jeu est préférable au niveau d'une articulation propre de manière a faciliter la manipulation du dispositif d'insertion, d'extraction et de verrouillage.

Les moyens élastiques pourront être situés au niveau d'une articulation propre ou de manière plus simple en être décalés.

Les moyens d'ancrage peuvent être une fourchette à deux dents, ces dents devant embrasser un bossage porté par la baie lors de l'ancrage.

Pour aider à l'insertion et à l'extraction du module, il est préférable que les dents aient des longueurs différentes, la dent la plus courte venant se loger entre le bossage et le module.

L'articulation commune peut être de type charnière. Pour faciliter la manipulation du dispositif d'insertion, d'extraction et de verrouillage, il est préférable qu'elle ménage un jeu entre les deux bras.

Les moyens susceptibles d'immobiliser l'un des bras par rapport à l'autre peuvent comporter une encoche portée par l'un des bras et un crochet, solidaire de l'autre bras, le crochet devant s'insérer dans l'encoche.

Pour éviter un désengagement accidentel de ces moyens d'immobilisation, on peut prévoir que le crochet soit maintenu inséré dans l'encoche par des moyens élastiques.

La présente invention sera mieux comprise à la lecture de la description d'exemples de réalisation illustrée par les figures qui représentent :
- la figure 1 une baie dans laquelle sont engagés des modules équipés de dispositifs d'insertion, d'extraction et de verrouillage selon l'invention ;
- les figures 2a à 2e, des coupes transversales schématiques d'un exemple de dispositif d'insertion, d'extraction et de verrouillage selon l'invention, depuis sa position déverrouillée jusqu'à sa position verrouillée ;
- les figures 3a, 3b deux vues de l'articulation propre à un bras d'un dispositif d'insertion, d'extraction et de verrouillage selon l'invention;
- la figure 3c une vue en éclaté de l'articulation commune aux deux bras d'un dispositif d'insertion, d'extraction et de verrouillage selon l'invention;
- la figure 3d une vue en éclaté des moyens d'immobilisation d'un bras par rapport à l'autre d'un dispositif d'insertion, d'extraction et de verrouillage selon l'invention;
- les figures 4a à 4e les positions prises par les moyens d'ancrage d'un dispositif d'insertion, d'extraction et de verrouillage selon l'invention et par le module au fond de la baie, entre la position verrouillée et la position déverrouillée;
- les figures 5a, 5b, 5c une vue respectivement en éclaté, de côté et une coupe d'une variante d'un dispositif d'insertion, d'extraction et de verrouillage selon l'invention.

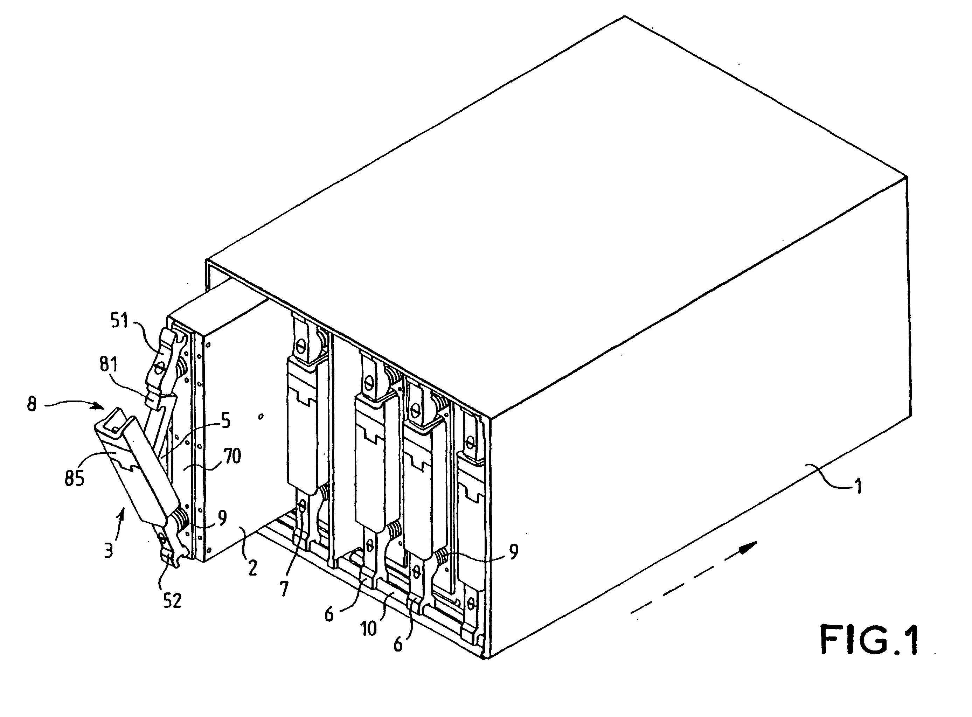

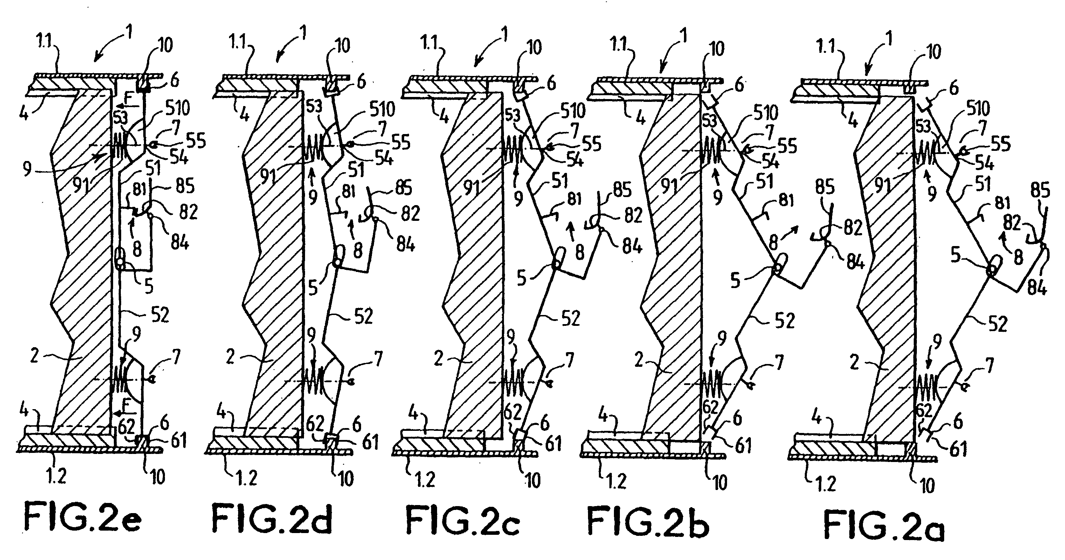

La figure 1 est une vue par l'avant, en perspective, d'une baie 1 contenant cinq modules 2 équipés du dispositif d'insertion, d'extraction et de verrouillage 3 selon l'invention. Ces modules 2 sont amovibles et ils ont une géométrie adaptée à celle de la baie. La baie 1 comporte de manière classique des moyens de guidage 4 disposés en vis-à-vis, par exemple des glissières en forme de U. Ces moyens de guidage 4 ne sont visibles que sur les figures 2, mais comme les figures sont des coupes longitudinales la forme en U est masquée.

Le module 2 de gauche n'est pas totalement engagé dans la baie 1 et le dispositif d'insertion, d'extraction et de verrouillage 3 selon l'invention est en position déverrouillée. Les autres modules 2 sont totalement engagés dans la baie 1 et connectés au fond de la baie 1 (au niveau de sa face arrière) et les dispositifs d'insertion, d'extraction et de verrouillage 3 sont dans une position verrouillée.

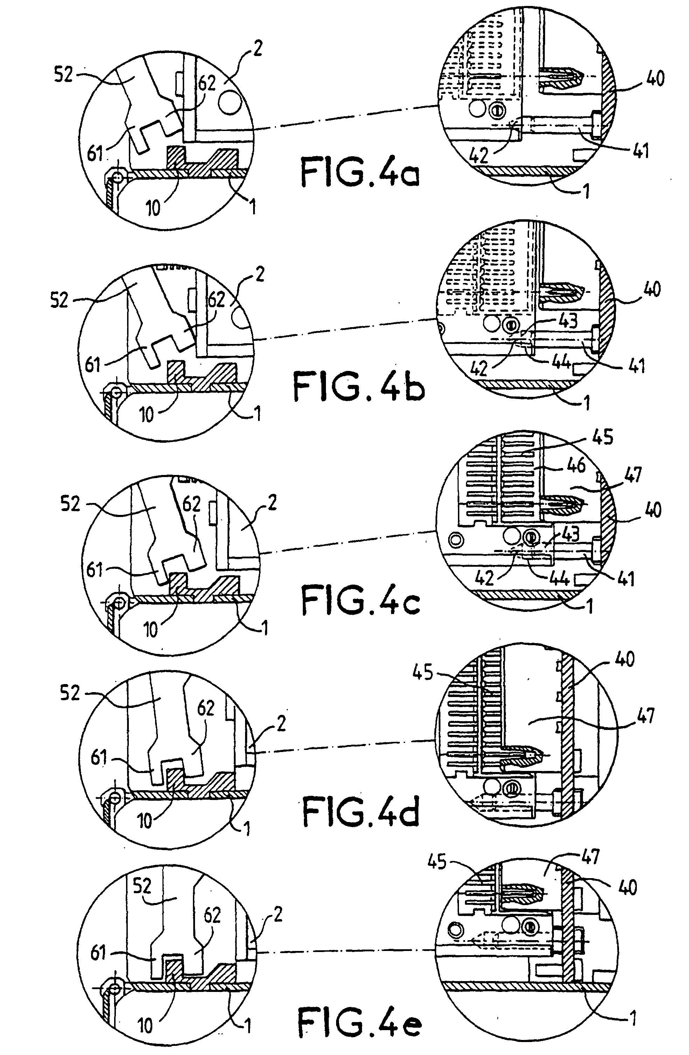

Des détails de la connexion des modules au fond de la baie seront donnés aux figures 4.

On va maintenant décrire la structure du dispositif d'insertion, d'extraction et de verrouillage 3 selon l'invention en se référant en particulier à la figure 2a. Le module 2 est représenté tronqué et hachuré. La baie 1, est vue seulement par ses faces supérieure 1.1 et inférieure 1.2.

Le dispositif d'insertion, d'extraction et de verrouillage selon l'invention comporte deux bras 51, 52, pivotants par rapport au module, reliés l'un à l'autre par une articulation 5 commune. Ces bras 51, 52 comportent chacun à l'une de leurs extrémités des moyens d'ancrage 6 dans la baie 1. Chaque bras 51, 52 comporte également une articulation 7 propre qui le relie au module 2 et autorise le pivotement par rapport au module 2. Cette articulation 7 est située entre l'articulation commune 5 et les moyens d'ancrage 6. Le dispositif d'insertion, d'extraction et de verrouillage 3 comporte aussi, coopérant avec les deux bras 51, 52, des moyens 8 susceptibles d'immobiliser l'un des bras 51, 52 par rapport à l'autre lorsque les moyens d'ancrage 6 sont ancrés dans la baie 1 et que le module 2 est connecté et solidarisé avec la baie 1. Cette position est illustrée à la figure 2e, c'est la position verrouillée du dispositif d'insertion, d'extraction et de verrouillage selon l'invention. Ces moyens 8 susceptibles d'immobiliser l'un des bras par rapport à l'autre sont indépendants du module 2.

Le dispositif d'insertion, d'extraction et de verrouillage 3 selon l'invention comporte également, associé à au moins un des bras 51, 52, des moyens élastiques 9 travaillant en compression, insérés entre le module 2 et le bras 51, 52 correspondant. Ils exercent sur le module 2 une force F de rappel vers l'intérieur de la baie 1 lorsque le dispositif d'insertion, d'extraction et de verrouillage 3 est en position verrouillée. Les flèches F sont visibles sur la figure 2e.

Les moyens d'ancrage 6 sont représentés sous forme d'une fourchette. Ils sont fixes par rapport aux bras. Chacune des fourchettes 6 possède deux dents 61, 62 et est destinée à coopérer avec la baie 1 au niveau d'un bossage 10 représenté sous la forme d'un rail. Les deux dents 61, 62 embrassent le rail 10 lorsque l'ancrage est réalisé. Les rails 10 sont placés à l'intérieur de la baie 1, l'un sur sa face supérieure 1.1 et un autre sur sa face inférieure 1.2 et sont orientés sensiblement transversalement à la direction d'insertion du module 2 dans la baie, cette direction étant matérialisée par une flèche en pointillés sur la figure 1. Cette figure ne montre que le rail 10 inférieur et il est commun aux différents dispositifs d'insertion, d'extraction et de verrouillage. Cette configuration n'est pas limitative.

Il est préférable pour faciliter l'extraction du module 2 de la baie 1 mais aussi son insertion, que les dents 61, 62 de la fourchette 6 aient des longueurs différentes. L'utilité de cette caractéristique sera expliquée plus loin lors de l'explication des différentes phases du mouvement donné au dispositif d'insertion, d'extraction et de verrouillage 3.

Pour faciliter la manipulation du dispositif d'insertion, d'extraction et de verrouillage, il est préférable que l'articulation propre 7 à chacun des bras 51, 52 procure un certain jeu entre le bras 51, 52 et le module 2. Cette articulation 7 peut comporter un axe 53 solidaire à une extrémité du module 2 et dont l'autre extrémité libre se projette à travers une lumière 54 portée par le bras 51, 52.

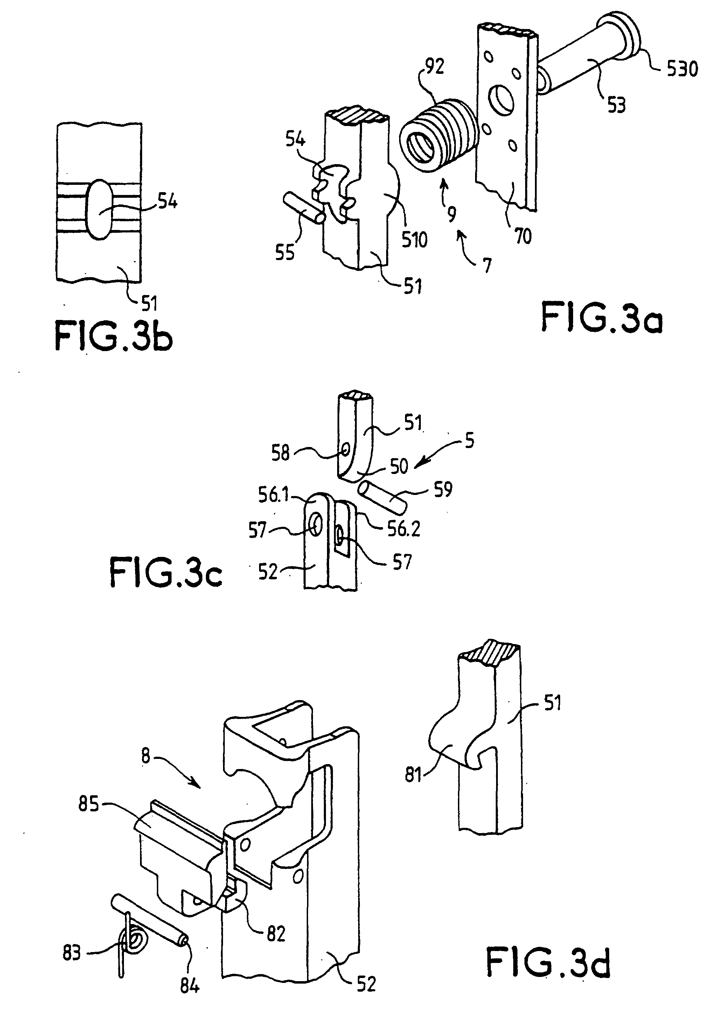

L'axe 53 est représenté sur la figure 3a comme un axe épaulé. Il passe au travers d'une platine 70 destinée à être fixée au module à l'aide de vis par exemple. L'épaulement 530 vient alors se loger entre le module 2 et la platine 70. Une goupille 55, blocable en translation, traverse l'axe 53 au niveau de son extrémité libre pour maintenir le bras 51, 52 enfilé sur l'axe 53.

La lumière 54 a de préférence une superficie supérieure à la section droite de l'axe 53, de manière conférer au bras 51, 52 le jeu requis permettant un pivotement aisé. Une lumière 54 de forme oblongue, visible sur la figure 3b, de grand axe orienté selon l'axe principal du bras 51, 52 par exemple, peut laisser un débattement de bas en haut au bras 51 permettant à la fourchette 6 de s'insérer sur le rail 10.

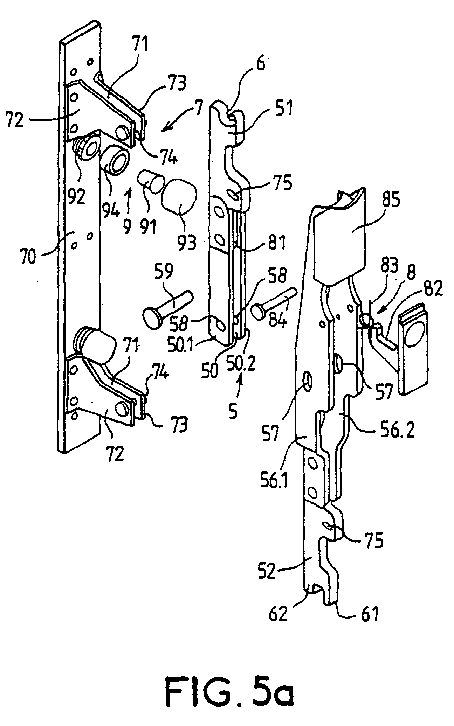

Sur la figure 5a qui montre en éclaté une variante d'un dispositif d'insertion, d'extraction et de verrouillage 3 selon l'invention, l'articulation propre 7 comporte une chape 71 solidaire du module 2, cette chape 71 possédant deux branches 72, 73 qui soutiennent un axe 74 de pivotement du bras 51, 52. Le bras 51, 52 vient se loger entre les deux branches 72, 73 de la chape 71. Le bras 51, 52 comporte, au niveau de l'articulation propre 7, une lumière 75 à travers de laquelle passe l'axe 74. Cet axe 74 peut être réalisé par exemple, par une vis et un écrou autofreiné.

La lumière 75 a de préférence un superficie supérieure à celle de la section droite de l'axe 74 de manière à conférer au bras 51, 52 le jeu voulu autorisant son inclinaison aisée. Une lumière 75 de forme oblongue, de grand axe orienté sensiblement transversalement à l'axe principal du bras 51, 52 permet d'obtenir le jeu voulu.

Dans l'exemple décrit, les deux branches 72, 73 de la chape 71 sont des équerres montées symétriquement par rapport au plan principal du bras 51, 52. Ces branches 72, 73 sont fixées sur une platine 70 de même nature que celle décrite à la figure 3a.

Un exemple d'articulation commune 5 est représenté sur la figure 3c, cette articulation 5 est de type charnière.

L'un des bras 52 se termine par deux branches 56.1, 56.2 portant chacune une lumière 57, les deux lumières 57 étant en vis-à-vis. L'autre bras 51 se termine par une partie 50 qui vient se loger entre les deux branches 56.1, 56.2, elle est équipée aussi d'au moins une lumière 58. Un goujon 59 blocable en translation réalise l'axe de la charnière en passant au travers des lumières 57, 58. Il est aussi préférable de laisser un certain jeu aux deux bras 51, 52, au niveau de l'articulation commune 5 pour faciliter l'actionnement du dispositif objet de l'invention. Les lumières 57 du bras 52 ou la lumière 58 du bras 51 ont, de préférence, une superficie supérieure à celle de la section droite du goujon 59. Sur la figure 3c par exemple, les lumières 57 sont représentées oblongues de grand axe orienté selon l'axe principal du bras 52 de manière à conférer aux deux bras 51, 52 le jeu voulu.

Sur la figure 5a, l'articulation commune 5 est tout à fait comparable à ce que l'on vient de décrire. Toutefois, une légère différence subsiste, elle est liée à la structure des moyens 8 susceptibles d'immobiliser l'un des bras 51 par rapport à l'autre 52. L'un des bras 52 se termine toujours par deux branches 56.1, 56.2. Au niveau de l'articulation commune 5, la partie 50 de l'autre bras 51 est dédoublée en deux branches 50.1, 50.2 pour loger un élément des moyens 8 décrits ultérieurement. Ces deux branches 50.1, 50.2. possèdent chacune une lumière 58 et ces lumières sont en vis à vis. On retrouve aussi le jeu entre les bras 51, 52 obtenu par des lumières 58, 57 oblongues sur l'un des bras 51, 52.

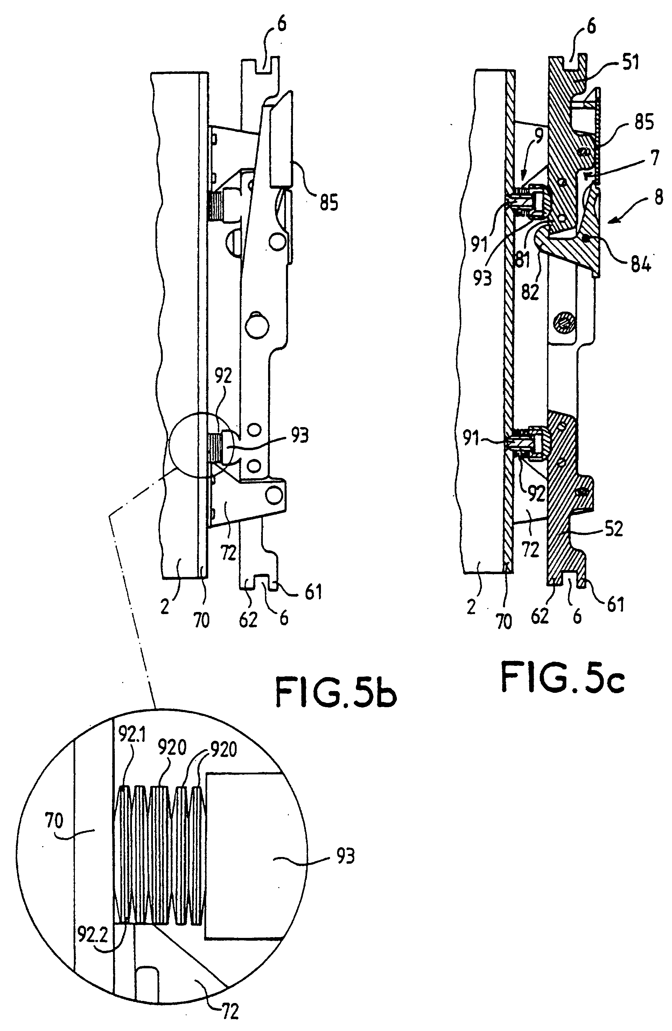

Dans les exemples décrits, des moyens élastiques 9 sont associés à chacun des bras 51, 52. Les moyens élastiques 9 sont situés, sur les figures 2 et 3a au niveau de l'articulation 7 propre à chacun des bras 51, 52, tandis que sur les figures 5 ils sont décalés par rapport aux articulations propres 7.

Sur les figures 2, les moyens élastiques 9 sont montés coulissants sur l'axe 53 et comportent un ou plusieurs ressorts 91. Ces ressorts 91 travaillent en compression en prenant appui d'un côté sur le bras 51, 52 correspondant et de l'autre sur le module 2. Les caractéristiques et le nombre de ressorts sont choisis en fonction des efforts auxquels le dispositif selon l'invention sera soumis.

La figure 3a montre en éclatée une variante des moyens élastiques 9. Ils comportent maintenant une ou plusieurs rondelles Belleville 92 qui coulissent autour de l'axe 53. Elles sont situées sur cette figure 3a entre la platine 70 et le bras correspondant 51. Cette variante permet, en choisissant le nombre de rondelles 92 et leur sens de montage d'atteindre pratiquement la raideur théorique voulue. Pour tenir compte du mouvement de pivotement que suit chacun des bras lors de l'ancrage, il est prévu que chacun des bras 51, 52 présente un bossage arrondi 510 dans la zone d'appui des moyens élastiques 9. Les moyens élastiques 9 viennent en butée sur ce bossage 510 quelle que soit la position des bras 51, 52.

Sur la figure 5b, un zoom de la zone des rondelles 92 Belleville montre une succession de paquets 920 de rondelles Belleville 92. Dans l'exemple, les paquets 920 ne comportent pas tous le même nombre de rondelles. Un paquet 920 comporte une ou plusieurs premières rondelles Belleville 92.1 montées dans un premier sens et une ou plusieurs secondes rondelles Belleville 92.2 montées dans un second sens, le premier sens étant opposé au second sens. Dans l'exemple, il y a cinq paquets 920 de rondelles Belleville, tous sauf un comportent une première rondelle Belleville 92.1 et une seconde rondelle Belleville 92.2, le paquet 920 central comporte lui deux premières rondelles Belleville 92.1 et deux secondes rondelles Belleville 92.2. D'autres arrangements seraient tout à fait possibles.

De tels moyens élastiques qu'ils comportent des ressorts ou des rondelles Belleville sont aisément adaptables à toute taille de modules quel que soit les efforts auxquels ils seront soumis.

Sur les figures 5, les moyens élastiques 9 associés à un bras 51, 52 sont maintenant décalés par rapport aux articulations propres 5, ce qui est plus simple à réaliser. Cette configuration présente de plus l'avantage de supprimer l'effort de friction et donc de faciliter l'insertion et l'extraction. Cela permet en outre de créer un couple dont la force a pour effet de faire pivoter les deux bras 51, 52 et de permettre leur saisie manuelle. Les moyens élastiques 9 coulissent maintenant sur un axe 91 ayant un pied solidaire d'un des deux éléments choisis entre le module 2 ou le bras 51, 52 et une extrémité libre qui se projette vers l'autre élément et est coiffée d'un cabochon 93 mobile en translation. Sur cet axe 91 sont enfilées les moyens élastiques qui sont ici des rondelles 92 Belleville. C'est par le cabochon 93 que les moyens élastiques 9 sont comprimés. Lorsque le cabochon 93 vient en butée contre le bras 51, 52 ou le module 2, il se rapproche en coulissant du pied de l'axe et écrase les moyens élastiques 9. Il répartit les efforts sur les moyens élastiques de manière homogène. Sur la figure 5a, le cabochon 93 a sa base solidaire d'une bague 94 qui coulisse sur l'axe 91 et qui sert d'interface entre les moyens élastiques et le cabochon.

Les moyens 8 susceptibles d'immobiliser l'un des bras 51, 52 par rapport à l'autre sont réalisés par un premier élément par exemple un crochet 82 qui vient coopérer avec un second élément par exemple une encoche 81. Le crochet 82 est solidaire de l'un des bras 52 et l'encoche 81 de l'autre 51.

Sur les figures 2, l'encoche 81 est située entre l'articulation 7 propre au bras 51 et l'articulation commune 5. Le crochet 82 est situé à l'opposé de l'articulation propre 7 au bras 52 par rapport à l'articulation commune 5. Dans l'exemple, le crochet 82 est mobile par rapport au bras 52, il est monté en rotation autour d'un axe 84 pour pouvoir être crocheté et décrochété aisément.

Les moyens 8 susceptibles d'immobiliser l'un des bras 51, 52 par rapport à l'autre comportent des moyens élastiques 83 pour éviter un désengagement accidentel du crochet 82 de l'encoche 81. Ces moyens élastiques 83 peuvent être réalisés par le matériau élastique du crochet ou de manière préférée par un ressort travaillant en torsion qui tend à ramener en permanence le crochet 82 dans une position angulaire correspondant à la position crochetée. Le crochet 82 peut se prolonger par un poussoir 85 qui lorsqu'il est sollicité, vient s'opposer à la force de rappel du ressort 83 travaillant en torsion. Cette structure est illustrée à la figure 3d.

Sur la figure 5a, les moyens 8 susceptibles d'immobiliser l'un des bras par rapport à l'autre sont tout à fait comparables à ce qui vient d'être présenté à la figure 3d. L'encoche 81 est située entre les deux branches 50.1, 50.2 du bras 51. Le bras 51 est configuré dans cet exemple en deux tronçons mis bout à bout le premier porte à une extrémité les moyens d'ancrage 6 et est pris en sandwich à l'autre extrémité entre les deux branches 50.1, 50.2 qui forment le second tronçon. L'encoche 81 se trouve à l'extrémité du premier tronçon entre les deux branches.

Un tel dispositif d'insertion d'extraction et de verrouillage avec ses deux bras pivotants par rapport au module, articulés l'un à l'autre a l'avantage de pouvoir être utilisé aisément en tant que poignée lors de la manipulation et/ou du transport du module.

On va voir maintenant la séquence d'étapes conduisant au dispositif d'insertion, d'extraction et de verrouillage selon l'invention et à la connexion d'un module. Ces étapes sont illustrées aux figures 4a à 4e à combiner avec les figures 2a à 2e qui montrent schématiquement les positions prises par le dispositif d'insertion, d'extraction et de verrouillage dans son ensemble.

Sur les figures 4a à 4e, deux cercles sont dessinés par étape, les cercles de gauche donnent, pour chaque étape, la position de l'un des bras 52 (le bras du bas) au niveau de ses moyens d'ancrage 6 et les cercles de droite la position du module 2 dans la baie 1.

La première étape qui correspond aux figures 2a et 4a est une étape de centrage du module. Le module 2 est introduit dans la baie 1 puis il est déplacé en translation, en le poussant manuellement, de manière à ce qu'il glisse dans les moyens de guidage 4 (non représentés sur les figures 4). Le fond 40 de la baie 1 comporte des pions de centrage 41 qui se projettent vers le module 2 et qui sont destinés à pénétrer dans un logement 42 porté par le module 2.

De manière classique, on peut prévoir que chaque module 2 comporte deux logements 42 devant accueillir chacun un pion centrage 41 et l'on donne à ces deux pions de centrage des dimensions différentes de manière à empêcher l'insertion d'un module dans un sens non voulu. Cette caractéristique n'est pas visible sur les figures, l'autre pion de centrage serait placé en haut de la baie.

Le dispositif d'insertion, d'extraction et de verrouillage est en position ouverte et ses bras 51, 52 inclinés. Ses moyens d'ancrage 6 ne coopèrent pas avec le rail 10 de la baie 1. Les moyens élastiques 9 ne sont pas comprimés (voir figure 2a). Les pions de centrage 41 et les moyens de guidage 4 contribuent à centrer le module 2 dans la baie 1.

L'étape suivante illustrée aux figures 2b et 4b est une étape de détrompage classique. Le fond 40 de la baie 1 comporte des moyens de détrompage 43 sous forme de téton plus court qu'un pion de centrage 41. Ils sont destinés à pénétrer dans un logement 44 porté par le module 2. La géométrie de la section du logement 44 correspond à celle de la section droite du téton 43.

Les différents modules 2 devant s'insérer dans la baie auront des logements 44 de géométrie différente de manière à empêcher d'insérer un module à une place qui ne lui est pas destinée.

Sur les figures 4a à 4e, les tétons 43 sont représentés derrière les pions de centrage 41, ce qui fait que l'on ne distingue que leur extrémité en pointillés.

Cette étape de détrompage est obtenue en continuant à déplacer en translation le module 2 pour le rapprocher du fond 40 de la baie 1. Les bras 52, 51 du dispositif d'insertion, d'extraction et de verrouillage sont toujours inclinés et libres.

L'étape suivante illustrée aux figures 2c et 4c est une étape de centrage des connexions. Le module 2 comporte dans des logements 46, des blocs de connexion 45 d'un premier type reliés aux cartes de circuit imprimé devant s'insérer dans des blocs de connexion 47 d'un second type reliés portés par la baie. Dans l'exemple les blocs de connexion 45 de premier type ont des contacts femelles et les blocs de connexion de second type des contacts mâles.

Lors de cette étape, les blocs de connexion 47 de second type sont présentés à l'orée des logements 46. Aucune connexion n'est réalisée à ce stade. Les bras 51, 52 ont toujours sensiblement la même inclinaison et les moyens d'ancrage 6 arrivent en contact avec un rail 10. On a vu que les moyens d'ancrage 6 étaient formés d'une fourchette à deux dents 61, 62 de longueurs différentes.

La dent 62 la plus courte est destinée à se placer entre le rail 10 et le module 2 tandis que la dent 61 la plus longue vient se placer de l'autre côté du rail 10. Au cours de cette étape la dent 61 la plus longue vient se bloquer contre le rail 10 mais le module 2 n'est pas encore en fin de course.

L'étape suivante consiste à redresser les deux bras 51, 52 sensiblement simultanément en agissant sur leur articulation commune 5. Cette étape illustrée aux figures 2d et 4d est celle qui réalise les connexions. Les blocs de connexion 47 de second type et ceux 45 de premier type s'accouplent. En faisant pivoter les deux bras 51, 52 pour les redresser les moyens d'ancrage 6 sont en prise sur le rail 10, la dent 62 la plus courte agrippe le rail . Lorsque les bras 51, 52 sont redressés et ancrés, les moyens élastiques 9 sont en compression et le module 2 en fin de course, en butée contre le fond de la baie . L'ancrage des deux bras de manière simultanée grâce à l'articulation commune garantit que le module est parfaitement connecté et est solidement maintenu dans la baie.

Dès que les bras 51, 52 se redressent, les moyens élastiques 9 se compriment et ils contribuent à vaincre la force nécessaire à la connexion en exerçant sur le module 2 une force de rappel vers l'intérieur de la baie 1. Cette force peut être importante, elle est de l'ordre de 100 grammes par contact et le nombre de contacts peut dépasser la centaine.

La demière étape illustrée aux figures 2e et 4e est celle du verrouillage du dispositif d'insertion, d'extraction et de verrouillage. Le module reste immobile. Les moyens 8 susceptibles d'immobiliser l'un des bras 51, 52 par rapport à l'autre sont activés. Le crochet 82 est inséré dans l'encoché 81. Les moyens élastiques 9 sont toujours en compression, ce qui garantit ainsi la qualité des connexions quel que soit l'environnement.

Le dispositif d'insertion, d'extraction et de verrouillage selon l'invention est polyvalent, il permet un découplage de l'effort d'insertion et de celui propre au maintien en position verrouillée.

Lors du déverrouillage du dispositif d'insertion, d'extraction et de verrouillage, après le désengagement du crochet 82 de l'encoche 81, les moyens d'ancrage 6 restent temporairement en prise sur le rail 10 alors que l'on commence à basculer les bras 51, 52. Les moyens élastiques 9 se décompriment et contribuent au désaccouplement des blocs de connexion 45, 47 de premier et de second type. Plus les bras 51, 52 pivotent, plus le module 2 se désengage de la baie 1. Les dents les plus courtes 62 se désengagent du rail 10 mais pendant un certain temps les dents les plus longues 61 restent bloquées contre le rail 10 et l'effet levier qu'elles procurent aident à l'extraction. L'effort à fournir pour la déconnexion et l'extraction est aussi important. Il faut ensuite déplacer le dispositif d'insertion, d'extraction et de verrouillage en translation pour pouvoir désengager totalement le module.

## Revendications

1. Dispositif d'insertion, d'extraction et de verrouillage d'un module (2) dans une baie (1), **caractérisé en ce qu'**il comporte :
- deux bras (51, 52) pivotants par rapport au module (2), articulés l'un à l'autre par une articulation commune (5), chacun d'entre eux (51, 52) comportant d'une part, à une extrémité, des moyens d'ancrage (6) dans la baie (1) et d'autre part une articulation (7) propre avec le module (2),
- des moyens (8) susceptibles d'immobiliser l'un des bras (51, 52) par rapport à l'autre lorsque les bras sont ancrés dans la baie (1) et
- associés à au moins un des bras (51, 52), des moyens élastiques (9) travaillant en compression entre le module (2) et ledit bras (51, 52) lorsque soh extrémité est ancrée dans la baie (1).

2. Dispositif d'insertion, d'extraction et de verrouillage selon la revendication 1, **caractérisé en ce que** les moyens élastiques (9) comportent un ou plusieurs éléments tels que des ressorts (91) ou des rondelles (92) Belleville.

3. Dispositif d'insertion, d'extraction et de verrouillage selon la revendication 2, **caractérisé en ce que** les moyens élastiques (9) comportent un ou plusieurs paquets (920) comprenant chacun une ou plusieurs premières rondelles Belleville (92.1) montées dans un premier sens et une ou plusieurs secondes rondelles Belleville (92.2) montées dans un second sens, le premier sens étant opposé au second sens.

4. Dispositif d'insertion, d'extraction et de verrouillage selon l'une des revendications 1 à 3, **caractérisé en ce que** l'articulation propre (7) à un bras (51, 52) comporte une chape (71) solidaire du module (2), cette chape (71) possédant deux branches (72, 73) qui soutiennent un axe (74) de pivotement passant au travers d'une lumière (75) du bras (51, 52).

5. Dispositif d'insertion, d'extraction et de verrouillage selon la revendication 4, **caractérisé en ce que** la lumière (75) est oblongue pour laisser un débattement au bras (51, 52).

6. Dispositif d'insertion, d'extraction et de verrouillage selon l'une des revendications 1 à 3, **caractérisé en ce que** l'articulation propre (7) à un bras (51, 52) comporte un axe (53) qui se projette depuis le module (2) à travers une lumière (54) portée par ledit bras (51, 52), le bras (51, 52) étant maintenu sur l'axe (53) par une goupille (55) blocable en translation.

7. Dispositif d'insertion, d'extraction et de verrouillage selon la revendication 6, **caractérisé en ce que** la lumière (54) est oblongue pour laisser un débattement au bras (51, 52).

8. Dispositif d'insertion, d'extraction et de verrouillage selon l'une des revendications 1 à 3, 6 ou 7, **caractérisé en ce** les moyens élastiques (9) sont situés au niveau d'une articulation propre (7).

9. Dispositif d'insertion, d'extraction et de verrouillage selon la revendication 8 en combinaison avec la revendication 6, **caractérisé en ce que** les moyens élastiques (9) sont enfilés sur l'axe (53).

10. Dispositif d'insertion, d'extraction et de verrouillage selon l'une des revendications 1 à 7, **caractérisé en ce que** les moyens élastiques (9) sont décalés par rapport à l'articulation propre (7) à un bras (51, 52).

11. Dispositif d'insertion, d'extraction et de verrouillage selon la revendication 10, **caractérisé en ce que** les moyens élastiques (9) associés à un bras (51, 52) coulissent sur un axe (91) ayant un pied solidaire d'un élément choisi entre le module (2) ou le bras (51, 52) et une extrémité libre qui se projette vers l'autre élément, cette extrémité libre étant coiffée d'un cabochon (93) mobile en translation, ce cabochon (93) comprimant les moyens élastiques (9) lorsqu'il vient en butée contre l'autre élément (51, 52, 2)

12. Dispositif d'insertion, d'extraction et de verrouillage selon l'une des revendications 1 à 11, **caractérisé en ce que** les moyens d'ancrage (6) sont une fourchette à deux dents (61, 62), ces dents (61, 62) devant embrasser un bossage (10) porté par la baie (1) lors de l'ancrage.

13. Dispositif d'insertion, d'extraction et de verrouillage selon la revendication 12, **caractérisé en ce que** les dents (61, 62) ont des longueurs différentes, la dent (62) la plus courte venant se loger entre le bossage (10) et le module (2).

14. Dispositif d'insertion, d'extraction et de verrouillage selon l'une des revendications 1 à 13, **caractérisé en ce que** l'articulation commune (5) est de type charnière.

15. Dispositif d'insertion, d'extraction et de verrouillage selon la revendication 14, **caractérisé en ce que** l'articulation commune (5) ménage un jeu entre les deux bras (51, 52).

16. Dispositif d'insertion, d'extraction et de verrouillage selon l'une des revendications 1 à 15, **caractérisé en ce que** les moyens (8) susceptibles d'immobiliser l'un des bras par rapport à l'autre comportent une encoche (81) portée par l'un des bras (51) et un crochet (82) solidaire de l'autre bras (52), le crochet devant s'insérer dans l'encoche.

17. Dispositif d'insertion, d'extraction et de verrouillage selon la revendication 16, **caractérisé en ce que** le crochet (82) est maintenu inséré dans l'encoche (81) par un élément élastique (83).

## Patentansprüche

1. Vorrichtung zum Einsetzen, Entnehmen und Verriegeln eines Moduls (2) in einem Gehäuse (1), **dadurch gekennzeichnet, daß** sie aufweist:
- zwei Arme (51, 52), die bezüglich des Moduls (2) schwenkbar und aneinander über ein gemeinsames Gelenk (5) angelenkt sind, wobei jeder Arm (51, 52) einerseits an einem Ende Verankerungsmittel (6) zur Verankerung im Gehäuse (1) und andrerseits ein eigenes Gelenk (7) bezüglich des Moduls (2) enthält,
- Mittel (8), die einen der Arme (51, 52) bezüglich des anderen fixieren können, wenn die Arme in dem Gehäuse (1) verankert sind,
- und elastische Mittel (9), die mindestens einem der Arme (51, 52) zugeordnet sind und in Kompressionsrichtung zwischen dem Modul (2) und dem Arm (51, 52) wirken, wenn das Ende des Moduls in dem Gehäuse (1) verankert ist.

2. Vorrichtung zum Einsetzen, Entnehmen und Verriegeln nach Anspruch 1, **dadurch gekennzeichnet, daß** die elastischen Mittel (9) eines oder mehrere Elemente wie Spiralfedern (91) oder Tellerfedern (92) besitzen.

3. Vorrichtung zum Einsetzen, Entnehmen und Verriegeln nach Anspruch 2, **dadurch gekennzeichnet, daß** die elastischen Mittel (9) eines oder mehrere Pakete (920) besitzen, die je eine oder mehrere Tellerfedern (92.1), die in einer ersten Richtung montiert sind, und eine oder mehrere zweite Tellerfedern (92.2) aufweisen, die in einer zweiten Richtung montiert sind, wobei die erste der zweiten Richtung entgegengesetzt ist.

4. Vorrichtung zum Einsetzen, Entnehmen und Verriegeln nach einem der Ansprüche 1 bis 3, **dadurch gekennzeichnet, daß** das eigene Gelenk (7) eines Arms (51, 52) einen Bügel (71) aufweist, der am Modul (2) befestigt ist und zwei Flügel (72, 73) besitzt, die eine durch ein Loch (75) im Arm (51, 52) verlaufende Schwenkachse (74) hält.

5. Vorrichtung zum Einsetzen, Entnehmen und Verriegeln nach Anspruch 4, **dadurch gekennzeichnet, daß** das Loch (75) ein Langloch ist, um dem Arm (51, 52) einen Bewegungsspielraum zu lassen.

6. Vorrichtung zum Einsetzen, Entnehmen und Verriegeln nach einem der Ansprüche 1 bis 3, **dadurch gekennzeichnet, daß** das eigene Gelenk (7) eines Arms (51, 52) eine Achse (53) aufweist, die vom Modul (2) ausgehend durch ein in dem Arm (51, 52) befindliches Loch (54) hindurchragt, wobei der Arm (51, 52) auf der Achse (53) durch einen in Translation blockierbaren Splint (55) gehalten wird.

7. Vorrichtung zum Einsetzen, Entnehmen und Verriegeln nach Anspruch 6, **dadurch gekennzeichnet, daß** das Loch (54) ein Langloch ist, um dem Arm (51, 52) einen Bewegungsspielraum zu lassen.

8. Vorrichtung zum Einsetzen, Entnehmen und Verriegeln nach einem der Ansprüche 1 bis 3, 6 und 7, **dadurch gekennzeichnet, daß** die elastischen Mittel (9) in Höhe eines eigenen Gelenks (7) der Arme liegen.

9. Vorrichtung zum Einsetzen, Entnehmen und Verriegeln nach Anspruch 8 kombiniert mit Anspruch 6, **dadurch gekennzeichnet, daß** die elastischen Mittel (9) auf die Achse (53) gesetzt sind.

10. Vorrichtung zum Einsetzen, Entnehmen und Verriegeln nach einem der Ansprüche 1 bis 7, **dadurch gekennzeichnet, daß** die elastischen Mittel (9) bezüglich des eigenen Gelenks (7) eines Arms (51, 52) versetzt sind.

11. Vorrichtung zum Einsetzen, Entnehmen und Verriegeln nach Anspruch 10, **dadurch gekennzeichnet, daß** die elastischen Mittel (9) eines Arms (51, 52) auf einer Achse (91) gleiten, die einen mit dem Modul (2) oder dem Arm (51, 52) fest verbundenen Fuß sowie ein freies Ende besitzt, das in Richtung zum anderen Element verläuft und mit einer translatorisch beweglichen Haube (93) bedeckt ist, die die elastischen Mittel (9) komprimiert, wenn die Haube sich auf dem Arm (51, 52) beziehungsweise dem Modul (2) abstützt.

12. Vorrichtung zum Einsetzen, Entnehmen und Verriegeln nach einem der Ansprüche 1 bis 11, **dadurch gekennzeichnet, daß** die Verankerungsmittel (6) von einer Gabel (6) mit zwei Zinken (61, 62) gebildet werden, die bei der Verankerung eine Erhöhung umgreifen sollen, die sich am Gehäuse (1) befindet.

13. Vorrichtung zum Einsetzen, Entnehmen und Verriegeln nach Anspruch 12, **dadurch gekennzeichnet, daß** die Zinken (61, 62) unterschiedliche Längen besitzen, wobei die kürzere Zinke (62) sich zwischen die Erhöhung (10) und dem Modul (2) schiebt.

14. Vorrichtung zum Einsetzen, Entnehmen und Verriegeln nach einem der Ansprüche 1 bis 13, **dadurch gekennzeichnet, daß** das gemeinsame Gelenk (5) ein Scharniergelenk ist.

15. Vorrichtung zum Einsetzen, Entnehmen und Verriegeln nach Anspruch 14, **dadurch gekennzeichnet, daß** das gemeinsame Gelenk (5) einen Bewegungsspielraum zwischen den beiden Armen (51, 52) zuläßt.

16. Vorrichtung zum Einsetzen, Entnehmen und Verriegeln nach einem der Ansprüche 1 bis 15, **dadurch gekennzeichnet, daß** die Mittel (8), mit denen ein Arm bezüglich des anderen fixiert werden kann, eine Nut (81) an einem der Arme (51) und einen Haken (82) an dem anderen Arm (52) aufweisen, wobei der Haken in die Nut eingreifen soll.

17. Vorrichtung zum Einsetzen, Entnehmen und Verriegeln nach Anspruch 16, **dadurch gekennzeichnet, daß** der Haken (82) in der Nut (81) durch ein elastisches Element (83) gehalten wird.

## Claims

1. Device for inserting, extracting and locking a module (2) into, from and in a rack (1), **characterized in that** it comprises:
- two arms (51, 52) which can pivot with respect to the module (2) and which are articulated together by a common articulation (5), each of them (51, 52) comprising, on the one hand, at one end, means (6) of anchoring it into the rack (1) and, on the other hand, a non-common articulation (7) with the module (2),
- means (8) capable of immobilizing one of the arms (51, 52) with respect to the other when the arms are anchored in the rack (1), and
- associated with at least one of the arms (51, 52), elastic means (9) working in compression between the module (2) and the said arm (51, 52) when its end is anchored into the rack (1).

2. Insertion, extraction and locking device according to Claim 1, **characterized in that** the elastic means (9) comprise one or more elements such as springs (91) or Belleville washers (92).

3. Insertion, extraction and locking device according to Claim 2, **characterized in that** the elastic means (9) comprise one or more packets (920), each comprising one or more first Belleville washers (92.1) mounted a first way round, and one or more second Belleville washers (92.2) mounted a second way round, the first way round being the opposite of the second.

4. Insertion, extraction and locking device according to one of Claims 1 to 3, **characterized in that** the non-common articulation (7) specific to one arm (51, 52) comprises a clevis (71) secured to the module (2), this clevis (71) having two branches (72, 73) which support a pivot (74) passing through a slot (75) in the arm (51, 52).

5. Insertion, extraction and locking device according to Claim 4, **characterized in that** the slot (75) is oblong to leave the arm (51, 52) free to move.

6. Insertion, extraction and locking device according to one of Claims 1 to 3, **characterized in that** the non-common articulation (7) specific to one arm (51, 52) comprises a pivot (53) which projects from the module (2) through a slot (54) in the said arm (51, 52), the arm (51, 52) being held on the pivot (53) by a pin (55) which can be prevented from translational movement.

7. Insertion, extraction and locking device according to Claim 6, **characterized in that** the slot (54) is oblong to leave the arm (51, 52) free to move.

8. Insertion, extraction and locking device according to one of Claims 1 to 3, 6 or 7, **characterized in that** the elastic means (9) are located in the region of a non-common articulation (7).

9. Insertion, extraction and locking device according to Claim 8 in combination with Claim 6, **characterized in that** the elastic means (9) are slipped onto the pivot (53).

10. Insertion, extraction and locking device according to one of Claims 1 to 7, **characterized in that** the elastic means (9) are offset with respect to the non-common articulation (7) specific to one arm (51, 52).

11. Insertion, extraction and locking device according to Claim 10, **characterized in that** the elastic means (9) associated with one arm (51, 52) slide along a pivot (91) having a base secured to an element chosen from the module (2) or the arm (51, 52), and a free end which projects toward the other element, this free end being capped with a cap (93) capable of moving in translation, and this cap (93) compressing the elastic means (9) when it comes into abutment against the other element (51, 52, 2).

12. Insertion, extraction and locking device according to one of Claims 1 to 11, **characterized in that** the anchoring means (6) are a two-pronged fork (61, 62), the prongs (61, 62) having to straddle a boss (10) borne by the rack (1) upon anchoring.

13. Insertion, extraction and locking device according to Claim 12, **characterized in that** the prongs (61, 62) have different lengths, the shorter prong (62) being received between the boss (10) and the module (2).

14. Insertion, extraction and locking device according to one of Claims 1 to 13, **characterized in that** the common articulation (5) is of the hinge type.

15. Insertion, extraction and locking device according to Claim 14, **characterized in that** the common articulation (5) leaves a clearance between the two arms (51, 52).

16. Insertion, extraction and locking device according to one of Claims 1 to 15, **characterized in that** the means (8) capable of immobilizing one of the arms with respect to the other comprise a notch (81) borne by one of the arms (51) and a hook (82) integral with the other arm (52), the hook having to be inserted in the notch.

17. Insertion, extraction and locking device according to Claim 16, **characterized in that** the hook (82) is kept inserted in the notch (81) by an elastic element (83).
